# EUROPEAN PATENT SPECIFICATION

(11) **EP 3 157 751 B1**
(45) Date of publication and mention of the grant of the patent: **11.05.2022**
(21) Application number: 15735776.5
(22) Date of filing: 17.06.2015
(51) Int. Cl.: B32B 27/08, B32B 27/18, B32B 27/20, H01B 17/56, H05K 9/00

(54) **INSULATION FILM AND METHOD FOR MAKING INSULATION FILM**
ISOLIERFOLIE UND VERFAHREN ZUR HERSTELLUNG DER ISOLIERFOLIE
FILM ISOLANT ET SON PROCÉDÉ DE FABRICATION

(30) Priority: 23.06.2014 US 201414312222
(43) Date of publication of application: 26.04.2017
(73) Proprietor: Illinois Tool Works Inc., Glenview, IL 60025 (US)
(72) Inventor: LIAO, Hongchuan, Glenview, Illinois 60025 (US); BENSON, Chris, Glenview, Illinois 60025 (US); LIANG, Yong, Glenview, Illinois 60025 (US); CARLSON, Tom, Glenview, Illinois 60025 (US)
(74) Representative: Trinks, Ole
(86) International application number: PCT/US2015/036133
(87) International publication number: WO 2015/200059

(56) References cited:
- JP-A- 2010 278 293
- JP-A- 2011 052 094
- US-A1- 2007 230 156
- US-A1- 2010 096 181

## Description

### Field of the Invention

The present invention relates to an insulation film.

### Background of the Invention

From JP 2011 052094 A, a thermally conductive sheet is known comprising an insulating-thermally conductive resin layer including a conductive and thermally conductive filler and a thermoplastic resin on one side or both sides of an electrically conductive-thermally conductive resin layer including a conductive and thermally conductive filler and a thermoplastic resin. Both resin layers include a block copolymer using ethylene and octene as main ingredients and are prepared by irradiation with an electron beam.

JP 2010 278 293 A discloses a heat-conductive film of a multilayer structure is manufactured by performing co-extrusion and film formation so that an insulation layer is arranged on one surface or each of both surfaces of a heat-conductive resin layer containing 10-90 vol.% of a filler having electric conductivity and heat conductivity. The resin constituting the heat-conductive resin layer is preferably a polyolefin resin, such as a LDPE, and MDPE, a HDPE, or a copolymer, such as an ethylene-methacrylic acid copolymer, an ethylene- methyl methacrylate copolymer, ethylene propylene copolymer, etc.

An insulation film is used to isolate various electronic devices or components to avoid malfunction caused by short circuiting, breakdown or the like between the electronic devices or components, or electronic elements in the electronic devices or components, and reduce the risk of catching fire of the electronic devices or components so as to guarantee normal operation of various electronic elements. For example, the insulation film is placed between a printed circuit board (PCB) containing various circuits and a metallic housing such as an aluminum or copper housing for preventing EMI (electromagnetic interference) to prevent problems such as short circuiting caused by contact between the various elements on the PCB and the metallic housing. In order to use the insulation film, the insulation film is required to have different operating properties. Furthermore, specific indices for the requirements for these properties of the insulation film vary with different requirements for insulation.

Therefore, it is desired to provide an insulation film which is produced at a lower cost, and exhibits better properties.

### Summary of the Invention

The present invention provides an insulation film, comprising a film first layer and a film second layer, wherein the film first layer is made of a first plastics material selected from the group consisting of , PC, PET, PI, PP, PA, and the first plastics material contains a heat conduction additive selected from the group consisting of carborundum, boron nitride, metal oxide, ; and the film second layer is made of a second plastics material selected from the group consisting of PC, PET, PI, PP, PA, and the plastic material contains conductive additives selected from the group consisting of carbon black, carbon fiber, metal powder, and conducting polymer, wherein a lower surface of the film first layer is bound together with an upper surface of the film second layer.

### Brief Description of Drawings

Fig. 1 is a schematic view of the insulation film according to an embodiment of the present invention;
Fig. 2 is a cross-sectional view of the insulation film of Fig. 1 taken along the line A-A in Fig. 1;
Fig. 3 is a schematic view of the insulation film according to another embodiment of the present invention;
Fig. 4 is a cross-sectional view of the insulation film of Fig. 3 taken along the line B-B in Fig. 3;
Fig. 5 is an exemplary view of a co-extruding process for producing the insulation film according to an embodiment of the present invention;
Fig. 6 is an exemplary view of another co-extruding process for producing the insulation film according to an embodiment of the present invention;
Fig. 7 is an exemplary view of a composite process for producing the insulation film according to an embodiment of the present invention;
Fig. 8 is an exemplary view of a composite process for producing the insulation film according to an embodiment of the present invention;
Fig. 9 illustrates a traditional structure of an electrical device (such as adapter) 900;
Fig. 10 illustrates the details of the structure of the electrical device (such as adapter).

### Detailed Description of Preferred Embodiments

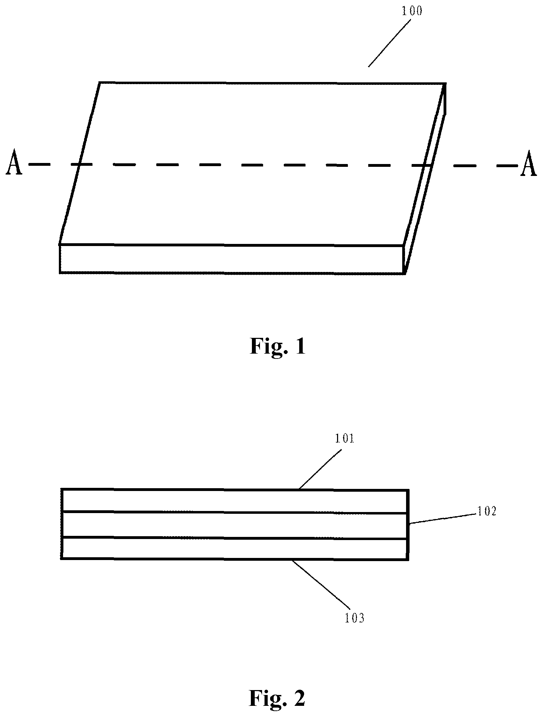

Fig. 1 illustrates a schematic view of an insulation film 100 according to an embodiment of the present invention. According to one embodiment of the present invention, the insulation film 100 can have a thickness of 0.05mm - 3.0mm. Fig. 2 is a cross-sectional view of the insulation film 100 of Fig. 1 taken along the line A-A in Fig. 1. As shown in Fig. 2, the insulation film 100 comprises an first layer 101, an second layer 102 and a third layer 103.

The first layer 101 and the third layer 103 of the insulation film 100 are made of insulation material, the insulation material can be plastics (such as PC, PET, PI, PP, PA, and so forth) containing heat conduction additives (such as carborundum, boron nitride, metal oxide, and so forth) to provide insulation and thermal conductivity. The second layer 102 of the insulation film 100 located between the first layer 101 and the third layer 103 of the insulation film 100 is made of plastics (such as PC, PET, PI, PP, PA, and so forth) and conductive additives (such as carbon black, carbon fiber, metal powder, and conducting polymer, and so forth) to meet the electrical conductivity, thermal conductivity and mechanical toughness. An upper surface of the film second layer 102 is bound together with a lower surface of the film first layer 101, a lower surface of the film second layer 102 is bound together with an upper surface of the film third layer 103.

An ordinary insulation material is not heat-conducting. Though a heat-conducting insulation film coated with thermally conductive adhesive has been presented in current market to increase the thermal conductivity, it usually can only be used as an interface heat conduction insulation material (the contact surface of different material is called an interface; the interface heat conduction insulation material is the heat conduction insulation material that needs the contact of surfaces, e.g., the interface heat conduction insulation material between the surfaces of electronic components and the surfaces of cooling fins), for the reason that the mechanical property of the adhesive is not good and the adhesive is sticky, and it is not convenient to use. In addition, the withstand voltage (or the breakdown voltage) is low. The heat conduction insulation film without adhesive is usually a thermoplastics material after modification, but the heat conduction of thermoplastics is usually crisp, not impact resistance and not resistant to fold, and thus cannot be made to a sheet film with a certain thinness (e.g., 0.2~0.8mm) to conveniently use,. When the present product requires the property of non-surface heat conduction insulation, it can be made to meet the usage requirements only by increasing the number of metal cooling fins and improving the grade of heat resistance of the components. However that leads to a higher product cost.

The insulation film 100 of the present invention has the following advantages:
(1) The conductive material of the second layer of the insulation film in the present invention uses a material that is of good mechanical toughness, or modified to increase toughness, so that crisp heat conduction insulation material can be attached to the second layer material of good mechanical toughness, and decrease the possibility of embrittlement of the surface layer. Thus the material can meet the requirement of punching and folding or the like processing as a whole;
(2) the conductive material (its thickness can be as low as 0.03mm) of the second layer in the invention is used for shielding the electromagnetic radiation and integrally has a certain mechanical strength to be formed, so that it can replace the thicker metal sheets in the present electrical products used by the customers and thus makes it convenient to design and reduces the cost for the customers;
(3) because the second layer also is of good thermal conductivity as the first layer and the third layer, the material is of good thermal conductivity (thermal coefficient is as high as 2.0W/(m •K)). In addition, the insulation film in the present invention has all the functions of insulation, thermal conductivity and shielding the electromagnetic radiation.

To a person skilled in the art, it is not easy (or obvious) to think of adding conductive additives (or materials) into an insulation film because an insulation film is traditionally used to perform insulation function between or among electronic components.

Through long-term observation, it was noticed that products using insulation material (e.g., the power adapter of a laptop) are required to be used inside some electrical products, while electrical circuit boards are needed to be surrounded by metal sheets to shield the electromagnetic radiation. These metal sheets are often thicker, approximately 0.3mm~0.6mm, to meet the product requirement (e.g., heat dissipation and strength requirement). Using the insulation film in the present invention to process insulating parts can omit the metal sheets inside the electrical products, but still retain the functions of heat dissipation and shielding the electromagnetic radiation. Compared with the present invention, traditional electronic products not only need more metal sheets to achieve the functions of heat dissipation and shielding the electromagnetic radiation, but also make it more complicated to be processed (for example, the metal sheets and insulating parts needed to be respectively punched, folded, assembled to surround the electrical circuit boards) with a higher process cost and greater odds of defective products.

Furthermore, it was found that the current regulatory standards (e.g., the international standard UL-60950 or IEC-60950) for the insulation film requires at least a thickness of 0.4mm for a single-layered insulation film made of a homogeneous material if supplementary insulation or reinforced insulation is required for the single-layered insulation film. However, the UL standard does not impose such requirement of thickness for a multi-layered insulation film comprising inseparable layers. The UL standard requires the voltage resistance of the multi-layered insulation film comprising inseparable layers to increase by 50%~100% and requires the multi-layered insulation film comprising inseparable layers to pass the additional Mandrel test. That is to say, even if a multi-layered insulation film comprising inseparable layers has a thickness of less than 0.4mm, it is considered as meeting the regulatory standards so long as it passes the stricter voltage withstanding test and the additional Mandrel test. The insulation film of the present invention is a multi-layered insulation film having inseparable multiple layers which are made of different materials, and it is found after experiments that the material for the insulation film of the present invention can exactly pass the stricter voltage withstanding test and the additional Mandrel test. Therefore, to meet the requirement under the regulatory standards, the thickness of the insulation film may be less than 0.4mm. In other words, as compared with the conventional single-layered insulation film, the insulation film according to the present invention has a reduced thickness, for example, the thickness of the insulation film can be reduced from 0.43mm to 0.25mm or thinner, while the insulation film according to the present invention can pass the stricter voltage withstanding test and the additional Mandrel test, thereby saving the material and cutting the production costs.

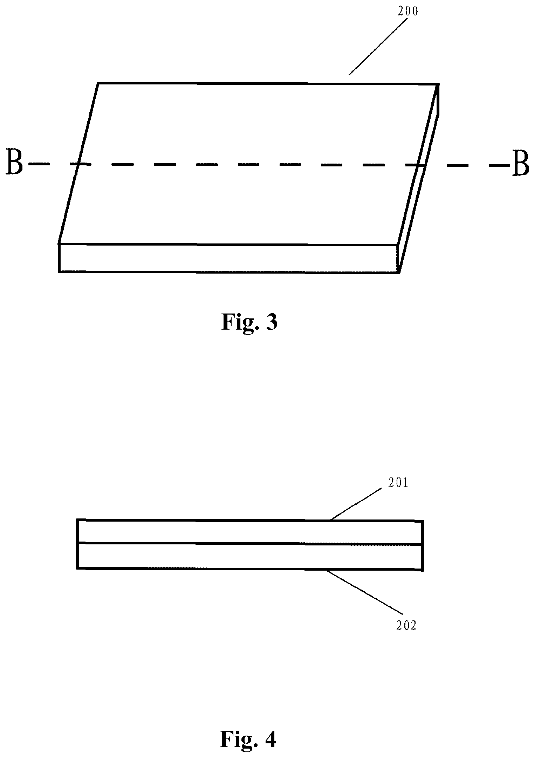

Fig. 3 is a schematic view of a film 200 according to another embodiment of the present invention. The only difference between the insulation film 200 and the insulation film 100 in Fig. 1 lies in that the insulation film 200 has a structure of two layers. Wherein the first layer 201 of the insulation film 200 in Fig. 2 is made of the same material as used by the first layer 101 of the insulation film 100 in Fig. 1; the second layer 202 of the insulation film 200 in Fig. 2 is made of the same material as used by the second layer 102 of the insulation film 100 in Fig. 1.

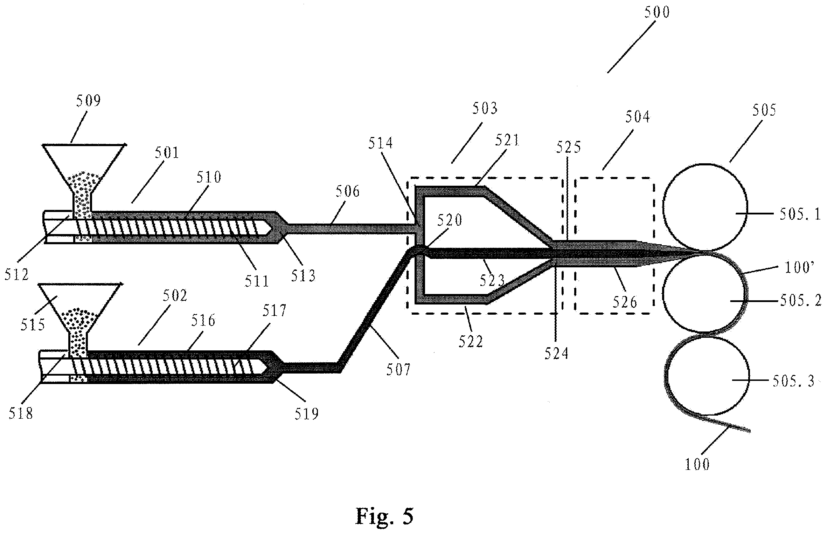

Fig. 5 illustrates a co-extruding assembly line 500 of a co-extruding process for producing the insulation film 100 according to an embodiment of the present invention. As shown in Fig. 5, the co-extruding assembly line 500 comprises a first extruder 501 and a second extruder 502. The first extruder 501 comprises a feeding hopper 509 and a receiving cavity 510. The feeding hopper 509 is configured to receive plastics (such as PC, PET, PI, PP, PA or the like) particles containing the heat conduction additives (such as carborundum, boron nitride, metal oxide, and so forth). The receiving cavity 510 is provided with a driving screw 511. An outlet of the feeding hopper 509 is communicated with a front end inlet 512 of the receiving cavity 510, a rear end outlet 513 of the receiving cavity 510 is communicated with an inlet of a pipe 506, and an outlet of the pipe 506 is communicated with a first inlet 514 of a dispenser 503. The second extruder 502 comprises a feeding hopper 515 and a receiving cavity 516. The feeding hopper 515 is configured to receive the plastics (such as PC, PET, PI, PP, PA, and so forth) containing conductive additives (such as carbon black, carbon fiber, metal powder, conducting polymer, and so forth). The receiving cavity 516 is provided with a driving screw 517. An outlet of the feeding hopper 515 is communicated with a front end inlet 518 of the receiving cavity 516, a rear end outlet 519 of the receiving cavity 516 is communicated with an inlet of a pipe 507, and an outlet of the pipe 507 is communicated with a second inlet 520 of the dispenser 503.

The first inlet 514 of the dispenser 503 is communicated with an inlet of a first branch line 521 and an inlet of the second branch line 522 of the dispenser, and the second inlet 520 of the dispenser 503 is communicated with an inlet of a third branch line 523 of the dispenser. As shown in Fig. 5, the third branch line 523 is located between the first branch line 521 and the second branch line 522. An outlet of the first branch line 521, an outlet of the second branch line 522 and an outlet of the third branch line 523 converge at an outlet 524 of the dispenser. The outlet 524 of the dispenser is connected to an inlet of a conduit 525, and an outlet of the conduit 525 is communicated with an inlet of a die cavity 526 of a die head 504. The die cavity 526 of the die head 504 has an appropriate width and depth so that the die cavity is sufficient to receive a material delivered from the pipe of the dispenser, and the die cavity 526 is flat so that the material delivered from the pipe of the dispenser is die pressed into a flat shape therein. The die pressed material is delivered through an outlet of the die cavity 526 to a forming roller apparatus 505. The forming roller apparatus 505 comprises a plurality of forming rollers placed adjacent to one another. The material delivered from the die cavity of the die head to the forming roller apparatus is stretched, roll pressed and cooled between the plurality of forming rollers to achieve a desired thickness and form a sheet material. Fig. 5 shows three such forming rollers 505.1, 505.2 and 505.3. Two or more forming rollers may be used in other embodiments.

According to the co-extruding assembly line 500 shown in Fig. 5, the insulation film 100 according to the present invention is produced in the following procedure.

During production, the receiving cavities 510 and 516 of the first extruder 501 and the second extruder 502 are heated, and the driving screws 511 and 517 of the first extruder 501 and the second extruder 502 are rotated. The plastics (such as PC, PET, PI, PP, PA or the like) particles containing the heat conduction additives (such as carborundum, boron nitride, metal oxide, etc.) are fed to the feeding hopper 509 of the first extruder 501. The rotation of the driving screw 511 of the first extruder 501 pushes the plastics particles containing the heat conduction additives in the feeding hopper 509 into the receiving cavity 510. Since the receiving cavity 510 is heated, the plastics particles containing the heat conduction additives, after entry into the receiving cavity 510, are melted due to heat generated from friction and are in a molten state. Affected by the pushing force generated by rotation of the driving screw 511, the plastics containing the heat conduction additives in the molten state is delivered to the rear end outlet 513 of the receiving cavity 510. The pushing force generated by rotation of the driving screw 511 enables the plastics containing the heat conduction additives in the molten state to flow out of the receiving cavity 510 from the rear end outlet 513 of the receiving cavity 510, and then enters the pipe 506 through the inlet of the pipe 506 communicated with the rear end outlet 513 of the receiving cavity 510. The plastics containing the heat conduction additives in the molten state flows out through the outlet of the pipe 506 to the first inlet 514 of the dispenser 503. At the inlet 514 of the dispenser, the plastics containing the heat conduction additives in the molten state is divided into two flows: one enters the first branch line 521 of the dispenser to become a first molten plastics containing heat conduction additives, and the other enters the second branch line 522 of the dispenser to become a second molten plastics containing heat conduction additives.

Similarly, the plastics (such as PC, PET, PI, PP, PA, etc.) particles containing conductive additives (such as carbon black , carbon fiber, metal powder, conducting polymer etc.) are fed to the feeding hopper 515 of the second extruder 502. The rotation of the driving screw 517 of the second extruder 502 pushes the plastics particles containing conductive additives in the feeding hopper 515 into the receiving cavity 516. Since the receiving cavity 516 is heated, the plastics particles containing conductive additives, after entry into the receiving cavity 516, are melted due to heat generated from friction and are in a molten state. Affected by the pushing force generated by rotation of the driving screw 517, the plastics containing conductive additives in the molten state is delivered to the rear end outlet 519 of the receiving cavity 516. The pushing force generated by rotation of the driving screw 517 enables the plastics containing conductive additives in the molten state to flow out of the receiving cavity 516 from the rear end outlet 519 of the receiving cavity 516, and then enters the pipe 507 through the inlet of the pipe 507 communicated with the rear end outlet 519 of the receiving cavity 516. The plastics containing conductive additives in the molten state flows out through the outlet of the pipe 507 to the second inlet 520 of the dispenser 503, and enters the third branch line 523 of the dispenser via the second inlet 503. Noticeably, the operation for the plastics particles containing conductive additives is performed at the same time as the previously-described operation for the plastics particles containing conductive additives

The first molten plastics containing heat conduction additives entering the first branch line 521 of the dispenser 503, the plastics containing conductive additives in the molten state entering the third branch line 523 of the dispenser 503 and the second molten plastics containing heat conduction additives entering the second branch line 522 of the dispenser 503 converge at the outlet 524 of the dispenser to thereby superimpose together, and then enters the die cavity 526 of the die head 504 via the conduit 525 communicated with the outlet 524 of the dispenser so that the molten PP is die pressed in the die cavity 526 to form a flat molten mass. The die pressed flat molten mass is delivered to between the forming rollers 505.1 and 505.2 to receive a stretching and pressing force applied by the forming rollers 505.1 and 505.2 thereto, and meanwhile it is cooled by the forming rollers 505.1 and 505.2 to thereby form a sheet or film 100' with a predetermined thickness. The film 100' continued to be fed between the forming rollers 505.2 and 505.3 for further cooling or annealing to form the insulation film or sheet 100 according to one embodiment of the present invention. As needed, the die pressed flat molten mass outputted from the die head may run through only two forming rollers or more than two forming rollers to form the film.

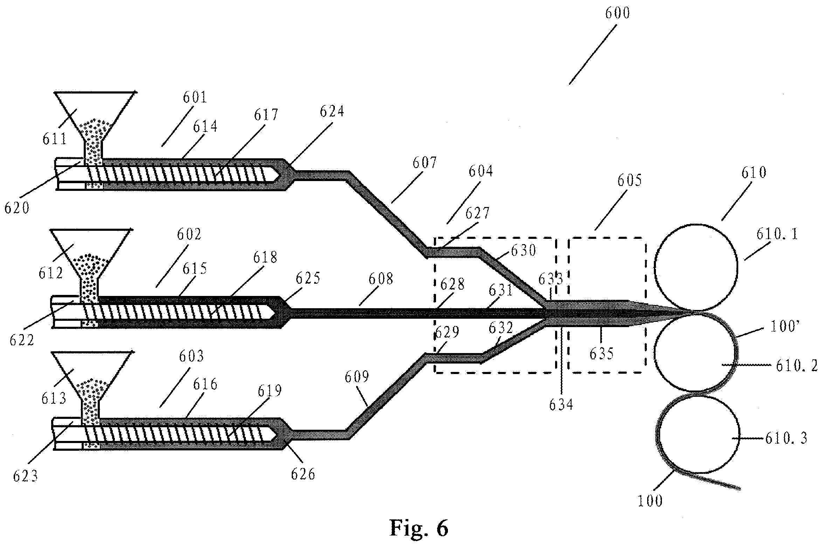

Fig. 6 illustrates a co-extruding assembly line 600 of another co-extruding process for producing the insulation film 100 according to an embodiment of the present invention. As shown in Fig. 6, the co-extruding assembly line 600 comprises a first extruder 601, a second extruder 602 and a third extruder 603. The first extruder 601, the second extruder 602 and the third extruder 603 respectively comprise a feeding hopper 611, 612, 613, a receiving cavity 614, 615, 616 and a driving screw 617, 618 and 619. The feeding hoppers of the first and third extruders 611 and 613 are configured to receive plastics (such as PC, PI, PP, PA, etc.) particles containing the heat conduction additives (such as carborundum, boron nitride, metal oxide, etc.). The feeding hopper of the second extruder 612 is configured to receive the plastics (such as PC, PET, PI, PP, PA, etc.) particles containing conductive additives (such as carbon black, carbon fiber, metal powder, conducting polymer, etc.). An outlet of the feeding hopper 611 of the first extruder 601 is communicated with a front end inlet 620 of the receiving cavity 614, a rear end outlet 624 of the receiving cavity 614 is communicated with an inlet of a pipe 607, and an outlet of the pipe 607 is communicated with a first inlet 627 of a dispenser 604. Similarly, an outlet of the feeding hopper 612 of the second extruder 602 is communicated with a front end inlet 622 of the receiving cavity 615, a rear end outlet 625 of the receiving cavity 615 is communicated with an inlet of a pipe 608, and an outlet of the pipe 608 is communicated with a second inlet 628 of the dispenser 604. An outlet of the feeding hopper 613 of the third extruder 603 is communicated with a front end inlet 623 of the receiving cavity 616, a rear end outlet 626 of the receiving cavity 616 is communicated with an inlet of a pipe 609, and an outlet of the pipe 609 is communicated with a third inlet 629 of the dispenser 604.

The first inlet 627 of the dispenser 604 is communicated with an inlet of a first branch line 630 of the dispenser, a second inlet 628 of the dispenser 604 is communicated with an inlet of a second branch line 631 of the dispenser, and a third inlet 629 of the dispenser 604 is communicated with an inlet of the of the third branch line 632 of the dispenser. As shown in Fig. 6, the second branch line 631 is located between the first branch line 630 and the third branch line 623. An outlet of the first branch line 630, an outlet of the second branch line 631 and an outlet of the third branch line 632 converge at an outlet 633 of the dispenser. The outlet 633 of the dispenser is communicated with an inlet of a conduit 634, and an outlet of the conduit 634 is communicated with an inlet of a die cavity 635 of a die head 605. The die cavity 635 of the die head 605 has an appropriate width and depth so that the die cavity is sufficient to receive a material delivered from the pipe of the dispenser, and the die cavity 635 is flat so that the material delivered from the pipe of the dispenser is die pressed into a flat shape therein. The die pressed material is delivered through an outlet of the die cavity 635 to a forming roller apparatus 610. The forming roller apparatus 610 comprises a plurality of forming rollers placed adjacent to one another. The material delivered from the die cavity of the die head to the forming roller apparatus is stretched, roll pressed and cooled between the plurality of forming rollers to achieve a desired thickness and form a sheet material. Fig. 6 shows three such forming rollers 610.1, 610.2 and 610.3. Two or more forming rollers may be used in other embodiments.

According to the co-extruding assembly line 600 shown in Fig. 6, the insulation film 100 according to the present invention is produced in the following procedure:
During production, the receiving cavities 614, 615 and 616 of the first extruder 601, the second extruder 602 and the third extruder 603 are heated, and the driving screws 617, 618 and 619 of the first extruder 601, the second extruder 602 and the third extruder 603 are rotated.

The plastics (such as PC, PET, PI, PP PA, etc.) particles containing the heat conduction additives (such as carborundum, boron nitride, metal oxide, etc.) are fed to the feeding hopper 611 of the first extruder 601. The rotation of the driving screw 617 of the first extruder 601 pushes the plastics particles containing the heat conduction additives in the feeding hopper 611 into the receiving cavity 614. Since the receiving cavity 614 is heated, the plastics particles containing the heat conduction additives, after entry into the receiving cavity 614, are melted due to heat generated from friction and are in a molten state. Affected by the pushing force generated by rotation of the driving screw 617, the plastics containing the heat conduction additives in the molten state is delivered to the rear end outlet 624 of the receiving cavity 614. The pushing force generated by rotation of the driving screw 617 enables the plastics containing the heat conduction additives in the molten state to flow out of the receiving cavity 614 from the rear end outlet 624 of the receiving cavity 614, and then enters the pipe 607 through the inlet of the pipe 607 communicated with the rear end outlet 624 of the receiving cavity 614. The plastics containing the heat conduction additives in the molten state flows out through the outlet of the pipe 607 to the first inlet 627 of the dispenser 604, and enters the first branch line 630 of the dispenser 604. The plastics particles containing the heat conduction additives entering the first branch line 630 of the dispenser 604 is a first molten plastics containing the heat conduction additives.

Similarly, the plastics particles containing the heat conduction additives are fed to the feeding hopper 613 of the third extruder 603. The plastics particles containing the heat conduction additives are delivered into the third branch line 632 of the dispenser 604 in the same manner as plastics particles containing the heat conduction additives in the feeding hopper 611 of the first extruder 601, and the plastics particles containing the heat conduction additives entering the third branch line 632 of the dispenser 604 is a second molten plastics containing the heat conduction additives.

The plastics (such as PC, PET, PI, PP, PA, etc.) particles containing the conductive additives (such as carbon black, carbon fiber, metal powder, conducting polymer, etc.) are fed to the feeding hopper 612 of the second extruder 602. The plastics particles containing conductive additives are delivered into the second branch line 631 of the dispenser 604 in the same manner as the plastics particles containing the heat conduction additives in the feeding hopper 611 of the first extruder 601.

Noticeably, operation is performed at the same time for delivering the plastics particles containing heat conduction additives and the plastics particles containing conductive additives respectively to the first branch line 630, the second branch line 631 and the third branch line 632.

Similar to the extruding process in the assembly line shown in Fig. 5, in Fig. 6 the first molten plastics containing heat conduction additives entering the first branch line 630 of the dispenser 604, the plastics containing conductive additives in the molten state entering the second branch line 631 of the dispenser 604 and the second molten plastics containing conductive additives entering the third branch line 632 of the dispenser converge at the outlet 633 of the dispenser to thereby superimpose together, and then enters the die cavity 635 of the die head 605 via the conduit 634 communicated with the outlet 633 of the dispenser so that the molten plastics is die pressed in the die cavity 635 to form a flat molten mass. The die pressed flat molten mass is delivered to between the forming rollers 610.1 and 610.2 to receive a stretching and pressing force applied by the forming rollers 610.1 and 610.2 thereto, to thereby form a sheet or film 100' with a predetermined thickness. The film 100' continued to be fed between the forming rollers 610.2 and 610.3 for further cooling or annealing to form the insulation film or sheet 100 according to one embodiment of the present invention. As needed, the die pressed flat molten mass outputted from the die head may run through only two forming rollers or more than two forming rollers to form the film.

The insulation film produced by the co-extruding process is of high quality, but the co-extruding process imposes high requirements for the apparatus. Therefore, the present invention further provides a method of producing the insulation film by a composite process, which imposes lower requirements for the apparatus.

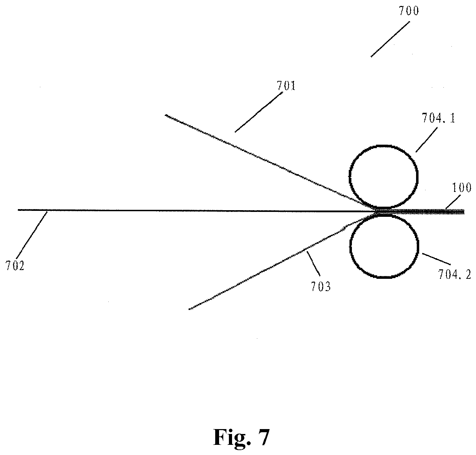

Fig. 7 is a composite assembly line 700 of a composite process for producing the insulation film 100 according to an embodiment of the present invention, comprising a pair of pressing rollers 704.1 and 704.2. An first layer 701, an second layer 702 and a third layer 703 of the insulation film 100 are respectively wound on three delivery rollers (not shown), and meanwhile inputted between the pressing rollers 704.1 and 704.2. When the pressing rollers 704.1 and 704.2 rotate relative to each other, a pulling force will be generated for the first layer 701, the second layer 702 and the third layer 703 so that the delivery rollers are moved to release the first layer 701, the second layer 702 and the third layer 703 respectively for the pressing rollers 704.1 and 704.2. As such, the first layer 701, the second layer 702 and the third layer 703 are wound between and run through between the pressing rollers 704.1 and 704.2 so that the first layer 701, the second layer 702 and the third layer 703 are pressed to form the insulation film 100.

In Fig. 7, the first layer 701 and the third layer 703 of the insulation film 100 is made of plastics material containing the heat conduction additives, and the second layer 702 of the insulation film 100 is the plastics material containing conductive additives (such as carbon black, carbon fiber, metal powder, conducting polymer, etc.). After the first layer 701, the second layer 702 and the third layer 703 of the insulation film 100 are released from respective delivery rollers and before they are wound between and run through the pressing rollers 704.1 and 704.2, a glue is applied to a lower surface of the first layer 701 and/or an upper surface of the second layer 702, and a glue is applied on a lower surface of the second layer 702 and/or an upper surface of the third layer 703 so that the first layer 701, the second layer 702 and the third layer 703 of the insulation film 100 are, after being pressed by the pressing rollers 704.01 and 704.02, adhered together to form the insulation film 100.

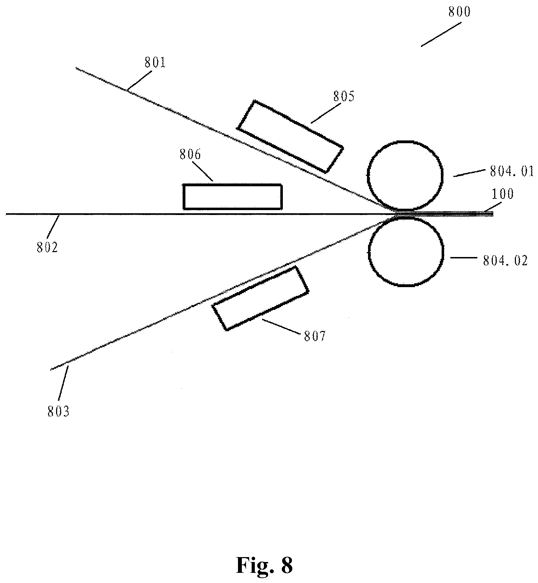

Fig. 8 is another composite assembly line 800 of a composite process for producing the insulation film 100 according to an embodiment of the present invention. The composite assembly line 800 in Fig. 8 is similar to the composite assembly line 700 of Fig. 7. The only difference therebetween is that in Fig. 8, a baker 805, 806 and 807 is respectively provided on one side of a path from the respective delivery rollers for an first layer 801, an second layer 802 and a third layer 803 of the insulation film 100 to between pressing rollers 804.01 and 804.02.

In Fig. 8, after the first layer 801, the second layer 802 and the third layer 803 of the insulation film 100 are released from respective delivery rollers and before they are wound between and run through the pressing rollers 804.1 and 804.2, the first layer 801, the second layer 802 and the third layer 803 of the insulation film 100 are heated by the respective bakers to soften them so that the first layer 801, the second layer 802 and the third layer 803 of the softened insulation film 100 are, after being pressed by the pressing rollers 804.01 and 804.02, adhered together to form the insulation film 100.

Although Fig. 8 only illustrates a method of heating the first layer 801, the second layer 802 and the third layer 803 of the insulation film via the bakers, those skilled in the art should appreciate that the first layer 801, the second layer 802 and the third layer 803 are softened in other manners to soften them.

It should be noted that any one value in the ranges of the values indicated in the present application is applicable to the present invention.

The insulation film in the present invention can be available in the composite structure of an electrical device. Generally speaking, the electrical device comprises a housing, a metal sheet layer of shielding and heat dissipation, an insulation film, an electronic component surrounding (or partially surrounding) the metal sheet layer of shielding and heat dissipation inside the insulation film from outside to inside. The electronic component includes a printed circuit board, on which electronic elements and circuit parts are installed. The insulation film in the present invention can be disposed between the interior of the housing and the electrical component. With this structure, it is not necessary to dispose an else shielding interlayer (usually a metal sheet layer) between the interior of the housing and the electrical component (or the printed circuit board).

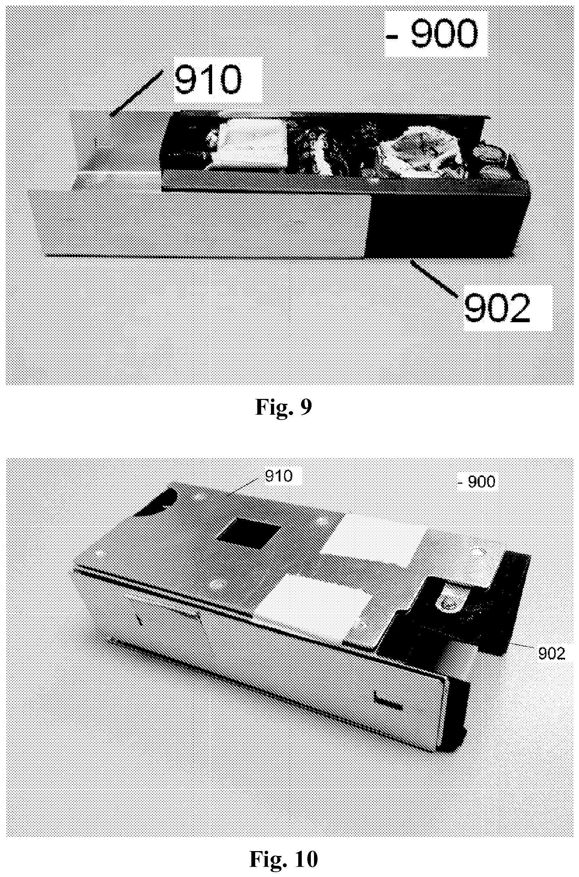

Fig. 9 illustrates the assembled structure of an electrical device (power adapter or power supply) 900. As shown in Fig. 9, the printed circuit board (not shown) is surrounded (or partially surrounded) by a traditional insulation film layer 902, while the traditional insulation film 902 is surrounded by a shielding interlayer (usually the metal sheet interlayer) 910, which has the function of preventing EMI (electromagnetic interference). The electronic elements and the circuit parts (such as resistors, capacitors, inductors, transistors, diodes, wires, pins, etc.) are installed on the printed circuit board. The printed circuit board surrounded by the traditional insulation film layer 902 and the shielding interlayer 910 is assembled within the housing.

Fig. 10 illustrates the details of the structure of a traditional electrical device. As shown in Fig. 10, the printed circuit board 102 is surrounded (or partially surrounded) by the traditional insulation film layer 902 and the shielding interlayer 910. It should be noted that any electrical device, the structure of which is similar to or the same as the assembled structure of the electrical device (power adapter or power supply) 900 illustrated in Fig. 9, can apply the insulation film 100, 200 in the present invention.

The shielding interlayer 910 in the electrical device 900 can be omitted when the traditional insulation film layer 902 is replaced by the insulation film in the present invention, for the reason that the insulation film has the function of preventing EMI (electromagnetic interference). Therefore, after the components of an electronic device are fully or partially wrapped by the insulation film of the present invention, the components, together with the print circuit board on which the components are installed, can be then installed within a housing (not shown) made of insulation material (such as plastic material) without needing the shielding interlayer 910 as shown in Figs. 9 and 10.

## Claims

1. An insulation film (100; 200), comprising:
a film first layer (101; 201), wherein the film first layer (101; 201) is made of a first plastics material selected from the group consisting of PC, PET, PI, PP, and PA, and the first plastics material contains a heat conduction additive selected from the group consisting of carborundum, boron nitride, and metal oxide; and
a film second layer (102; 202), wherein the film second layer (102; 202) is made of a second plastics material selected from the group consisting of PC, PET, PI, PP, and PA, and the plastics material contains conductive additives selected from the group consisting of carbon black, carbon fiber, metal powder, and conducting polymer, wherein a lower surface of the film first layer (101; 201) is bound together with an upper surface of the film second layer (102; 202).

2. The insulation film according to claim 1, comprising a third layer (103) identical to the first layer (101) bound together with a lower surface of the film second layer (102).

3. An electronic component, comprising a printed circuit board, on which electronic elements and circuit parts are installed, the printed circuit board surrounded or partially surrounded by an insulation film (100; 200) as defined in claim 1 or 2.

4. The electronic component according to claim 3, wherein the electronic component is used in an electronic device (900), wherein the electronic device (900) comprises a housing, in which the electronic component is installed, the insulation film (100; 200) is located between the housing and the printed circuit board without other shielding interlayers located between the housing and the printed circuit board within the housing.

5. The electronic component according to claim 3 or 4, wherein the electronic component is an adapter.

6. The electronic component according to claim 3 or 4, wherein the electronic component is a power supply.

## Patentansprüche

1. Isolierfolie (100; 200), aufweisend:
eine erste Folienschicht (101; 201), wobei die erste Folienschicht (101; 201) aus einem ersten Kunststoffmaterial hergestellt ist, das aus der Gruppe ausgewählt ist, die aus PC, PET, PI, PP und PA besteht, und das erste Kunststoffmaterial einen Wärmeleitungszusatzstoff enthält, der aus der Gruppe ausgewählt ist, die aus Carborund, Bornitrid und Metalloxid besteht; und
eine zweite Folienschicht (102; 202), wobei die zweite Folienschicht (102; 202) aus einem zweiten Kunststoffmaterial hergestellt ist, das aus der Gruppe ausgewählt ist, die aus PC, PET, PI, PP und PA besteht, und das Kunststoffmaterial leitfähige Zusatzstoffe enthält, die aus der Gruppe ausgewählt sind, die aus Ruß, Kohlefaser, Metallpulver und leitfähigem Polymer besteht, wobei eine untere Oberfläche der ersten Folienschicht (101; 201) mit einer oberen Oberfläche der zweiten Folienschicht (102; 202) verbunden ist.

2. Isolierfolie nach Anspruch 1, aufweisend eine dritte Schicht (103), die mit der ersten Schicht (101) identisch ist, die mit einer unteren Oberfläche der zweiten Folienschicht (102) verbunden ist.

3. Elektronisches Bauteil, aufweisend eine Leiterplatte, auf der elektronische Elemente und Schaltungsteile installiert sind, wobei die Leiterplatte von einer Isolierfolie (100; 200) umgeben oder teilweise umgeben ist, wie in Anspruch 1 oder 2 definiert.

4. Elektronisches Bauteil nach Anspruch 3, wobei das elektronische Bauteil in einer elektronischen Vorrichtung (900) verwendet wird, wobei die elektronische Vorrichtung (900) ein Gehäuse aufweist, in dem das elektronische Bauteil installiert ist, wobei die Isolierfolie (100; 200) zwischen dem Gehäuse und der Leiterplatte angeordnet ist, ohne dass andere abschirmende Zwischenschichten zwischen dem Gehäuse und der Leiterplatte innerhalb des Gehäuses angeordnet sind.

5. Elektronisches Bauteil nach Anspruch 3 oder 4, wobei das elektronische Bauteil ein Adapter ist.

6. Elektronisches Bauteil nach Anspruch 3 oder 4, wobei das elektronische Bauteil eine Energieversorgung ist.

## Revendications

1. Film isolant (100 ; 200), comprenant :
une première couche de film (101 ; 201), dans laquelle la première couche de film (101 ; 201) est faite d'une première matière plastique sélectionnée parmi le groupe constitué de PC, PET, PI, PP et PA, et la première matière plastique contient un additif de conduction thermique sélectionné parmi le groupe constitué de carborundum, nitrure de bore et oxyde métallique ; et
une deuxième couche de film (102 ; 202), dans laquelle la deuxième couche de film (102 ; 202) est faite d'une deuxième matière plastique sélectionnée parmi le groupe constitué de PC, PET, PI, PP et PA, et la matière plastique contient des additifs conducteurs sélectionnée parmi le groupe constitué de noir de carbone, de fibre de carbone, de poudre métallique et de polymère conducteur, dans lequel une surface inférieure de la première couche de film (101 ; 201) est liée ensemble avec une surface supérieure de la deuxième couche de film (102 ; 202).

2. Film isolant selon la revendication 1, comprenant une troisième couche (103) identique à la première couche (101) liée ensemble avec une surface inférieure de la deuxième couche de film (102).

3. Composant électronique, comprenant une carte de circuit imprimé, sur laquelle des éléments électroniques et des parties de circuit sont installés, la carte de circuit imprimé étant entourée ou partiellement entourée par un film isolant (100 ; 200) tel que défini dans la revendication 1 ou 2.

4. Composant électronique selon la revendication 3, dans lequel le composant électronique est utilisé dans un dispositif électronique (900), dans lequel le dispositif électronique (900) comprend un logement, dans lequel le composant électronique est installé, le film isolant (100 ; 200) est situé entre le logement et la carte de circuit imprimé sans autres couches intermédiaires de protection situées entre le logement et la carte de circuit imprimé à l'intérieur du logement.

5. Composant électronique selon la revendication 3 ou 4, dans lequel le composant électronique est un adaptateur.

6. Composant électronique selon la revendication 3 ou 4, dans lequel le composant électronique est une alimentation électrique.
